Europäisches Patentamt

European Patent Office

Office européen des brevets

(11) Veröffentlichungsnummer : **0 367 984 B1**

(12) **EUROPÄISCHE PATENTSCHRIFT**

(45) Veröffentlichungstag der Patentschrift :
**09.09.92 Patentblatt 92/37**

(51) Int. Cl.$^5$: **H03K 5/153,** H03K 17/13,
H02M 3/337, H02M 3/335

(21) Anmeldenummer : **89118340.2**

(22) Anmeldetag : **03.10.89**

(54) **Verfahren und Schaltungsanordnung zur Erhöhung des maximal möglichen Wirkungsgrades, der maximal möglichen Frequenz und des maximal möglichen Ausnutzungsgrades der Leistungs-Bauelemente in Resonanzwandler-Schaltnetzteilen mit Nulldurchgangsdetektor.**

(30) Priorität : **07.11.88 DE 3837749**

(43) Veröffentlichungstag der Anmeldung :
**16.05.90 Patentblatt 90/20**

(45) Bekanntmachung des Hinweises auf die
Patenterteilung :
**09.09.92 Patentblatt 92/37**

(84) Benannte Vertragsstaaten :
**DE FR GB IT NL**

(56) Entgegenhaltungen :
**US-A- 4 727 469**

(56) Entgegenhaltungen :
**IEEE TRANSACTIONS ON INDUSTRY APPLI-
CATIONS. vol. IA-21, no. 6, November 1985,
NEW YORK US, Seiten 1354-1358; D.A. Pas-
sey& C.F. Chen: "Arc Suppression of a DC
Energized Contactor Under Inductive Load"
IBM Technical Disclosure Bulletin vol. 20, no.
7, Dezember 1977, LONDON GB, Seiten
2716-2717; Braquet et al: "Circuit forpresynchronization of an alternating signal insertion
relay"
NEW ELECTRONICS. November 1988, LON-
DON GB, Seiten 42-56; "Resonance is the key
to power density"**

(73) Patentinhaber : **SIEMENS
AKTIENGESELLSCHAFT
Wittelsbacherplatz 2
W-8000 München 2 (DE)**

(72) Erfinder : **Erckert, Ricardo, Dipl.-Ing.
Schwaneckstrasse 2
W-8000 München 70 (DE)**

EP 0 367 984 B1

**Beschreibung**

Die Erfindung betrifft Resonanzwandler-Schaltnetzteile mit Nulldurchgangsdetektor nach dem Oberbegriff des Patentanspruches I.

Nulldurchgangsdetektoren sind allgemein insbesondere aus dem "Linear Applications Handbook", I980 von National Semiconductor auf den Seiten AN3I-I7, AN4I-2, AN4I-3, AN74-5, LB6-2 und LBI2-2 bekannt. Auf Seite AN3I-I7 wird ein schneller Nulldurchgangsdetektor gezeigt, der eine Signallaufzeit von ca. 200 ns aufweist.

Eine Einsatzmöglichkeit für Nulldurchgangsdetektoren liegt bei der Ansteuerung der Schalttransistoren von Resonanzwandler-Schaltnetzteilen.

Resonanzwandler-Schaltnetzteile sind unter anderem aus der US-A-3,596,I65, der US-A-4,464,709, der US-A-4,535,399 und der EP-AI-0 293 874 sowie den Datenblättern der Firma Unitrode Integrated Circuit Corporations für die Bauelemente UCI860 bzw. UC3860 bekannt. Bei solchen Schaltnetzteilen werden die Schalttransistoren weitgehend leistungslos, d.h. entweder bei vernachlässigbar kleinem Strom (Zero Current Switch) oder vernachlässigbar kleiner Spannung (Zero Voltage Switch) ein- bzw. ausgeschaltet. Der Vorteil beider Verfahren liegt darin, daß leistungslos geschaltet wird und somit gegenüber sonstigen Schaltnetzteilen eine um etwa eine Größenordnung höhere Schaltfrequenz erzielt werden kann. Zero-Voltage-Switch-Schaltungen bieten zusätzlich den Vorteil, daß parasitäre Kapazitäten im Transformator des Schaltnetzteiles nicht umgeladen werden müssen, jedoch darf die Last des Schaltnetzteiles nur in engen Grenzen variabel sein. Zero-Current-Switch-Schaltungen sind für den Weitlastbereich geeignet, in ihrem Trafo müssen jedoch die parasitären Bauelemente umgeladen werden, was unter anderem zu einer Begrenzung der möglichen maximalen Schaltfrequenz führt.

Die US-A-3,596,I65 sowie die US-A-4,464,709 zeigen selbstschwingende Resonanzwandler-Schaltnetzteile, die nach dem Gegentaktprinzip arbeiten und bei denen die Schwingung jeweils in Abhängigkeit vom Nulldurchgang unterbrochen wird. Die beiden Leitungsschalttransistoren werden nicht im Stromnulldurchgang umgeschaltet sondern lediglich abgeschaltet. Die Frequenz der Ansteuersignale der Schalttransistoren wird nicht der Eigenfrequenz des Resonanzkreises nachgeführt und zur Regelung der Ausgangsspannung wird lediglich der Arbeitspunkt des Resonanzkreises aus dem Resonanzpunkt verschoben, so daß der Resonanzkreis in Abhängigkeit von der Eingangsspannung und der Last oberhalb bzw. unterhalb seiner Resonanzfrequenz betrieben wird.

Solche Schaltnetzteile arbeiten beispielsweise nach dem Halbwellenprinzip, d.h., daß der Primärstrom nach jeder Halbwelle für eine bestimmte Zeit auf Null bleibt. Eine Nulldurchgangsdetektion ist nicht vorgesehen. Um zu verhindern, daß ein Transistor eingeschaltet wird, bevor der andere ausgeschaltet ist, kann der jeweils andere Transistor beim Einschalten des jeweils einen Transistors beispielsweise durch ein Monoflop gesperrt werden. Hierbei muß die durch das Monoflop vorgesehene Sperrzeit mindestens so groß sein, wie die im ungünstigsten Fall auftretende, längste Dauer einer Primärstromhalbwelle, die vornehmlich von den zulässigen Streuungsbreiten der Last, der Versorgungsspannung und des Trafos bestimmt wird. Die maximale Schaltfrequenz ist hierbei durch das Monoflop festgelegt. Der Ausnutzungsgrad der einzelnen Leistungs-Bauelemente des Schaltnetzteiles sowie der Wirkungsgrad sind bei solchen Schaltungen nicht besonders hoch.

Die US-A-4,535,399 zeigt ein nach dem Gegentaktprinzip arbeitendes Resonanzwandler-Schaltnetzteil, bei dem die Regelung der Ausgangsspannung über die Kombination eines PLL-Regelkreises mit dem Prinzip der Pulsbreitenmodulation erfolgt. Über den PLL-Regelkreis werden die Ansteuerfrequenz und die Frequenz des Resonanzkreises synchronisiert. Der Resonanzkreis wird oberhalb seiner Eigenfrequenz betrieben. Zur Synchronisierung dieser beiden Frequenzen wird der Primärstrom des Wandlers über eine Begrenzungsstufe des PLL-Kreises zugeführt. Eine Erfassung der Stromnulldurchgänge und die damit verbundene automatische Nachregelung der Ansteuerfrequenz an die Eigenfrequenz des Resonanzkreises ist nicht vorgesehen. Die Regelung der Ausgangsspannung erfolgt über den nach dem Prinzip der Pulsweitenmodulation arbeitenden Regler. Die Einschaltdauer der beiden Leistungstransistoren hängt dabei direkt von der Ausgangslast bzw. der Eingangsspannung des Resonanzwandlers ab. Dadurch kann nur in einem engen Last- bzw. Eingangsspannungsbereich im Stromnulldurchgang abgeschaltet werden, die Kommutierung des Resonanzkreises wird erzwungen.

Die EP-AI-0 293 874 zeigt Resonanzwandlerschaltnetzteile mit einem Regelverfahren, bei dem die Ansteuerfrequenz in Abhängigkeit von der sekundären Belastung an die jeweilige Eigenfrequenz angepaßt wird. Hierzu wird über einen Nulldurchgangsdetektor der Nulldurchgang des Primärstromes erfaßt und dieser tatsächlich vorliegende Nulldurchgang als Kriterium für das Einschalten und das Ausschalten der Schalttransitoren herangezogen. Dadurch ist die maximale Schaltfrequenz nicht mehr von der Halbwellenform des Primärstromes abhängig, die sich bei ungünstigster Eingangsspannung und ungünstigsten Lastverhältnissen einstellt, so daß der Wirkungsgrad solcher Schaltnetzteile größer ist als der Wirkungsgrad vorgenannter Schaltnetzteile.

2

Bei hoher Schaltfrequenz macht sich jedoch die Signallaufzeit in dem über den Nulldurchgangsdetektor angesteuerten Regelkreis bemerkbar. Die positive und die negative Halbwelle können bei solchen Schaltnetzteilen nicht unmittelbar nacheinander geschaltet werden, zwischen dem Ausschalten des die eine Halbwelle durchschaltenden Transistors und dem Einschalten des die andere Halbwelle durchschaltenden Transistors ist eine Pause in der Größe der Signallaufzeit der Regelschleife erforderlich. Den dominanten Anteil zur Signallaufzeit der Regelschleife liefern üblicherweise die Treiberstufen, die diesen nachgeschalteten Koppelnetzwerk sowie die Schalttransistoren.

Um die durch die Signallaufzeit in der Regelschleife hervorgerufenen Nachteile zu verringern, kann ein Nulldurchgangsdetektor mit Vorhalt, daß heißt, welcher vor dem tatsächlichen Nulldurchgang anspricht eingesetzt werden, wobei die Vorhaltezeit so groß ist wie die Signallaufzeit durch die Regelschleife. Hierzu ist es möglich, einen Nulldurchgangsdetektor mit festem Vorhaltepegel vorzusehen, bei dem sich die Vorhaltezeit aus der Flankensteilheit der detektierten elektrischen Größe ergibt, also einen Nulldurchgangsdetektor mit einem höheren Schwellwert. In diesem Fall muß jedoch der Vorhalt so gewählt werden, daß die Vorhaltezeit für die ungünstigste, noch zulässige Halbwellenform des Primärstromes, die von der Eingangsspannung und der Last abhängt, maximal so groß ist wie die Signallaufzeit durch die Regelschleife. Dadurch wird auch bei üblichen Schaltnetzteilen, deren Regelung einen Nulldurchgangsdetektor mit vorhalt enthält, der Wirkungsgrad und die maximale Schaltfrequenz durch die Kombination der ungünstigsten Last und der ungünstigsten Eingangsspannung sowie durch die zulässige Streuung der Bauelemente begrenzt. Dies gilt sowohl für Zero-Voltage-Switch-Schaltnetzteile als auch für Zero-Current-Switch-Schaltnetzteile.

Unter anderem aus der US-A-4,727,469 (Kammiller) sowie teilweise aus der US-A-4,587,604 ist ein geregeltes Gegentakt-Serien-Resonanzwandler-Schaltnetzteil für gattungsgemäße Verfahren bekannt. Kammiller beschreibt ein Schaltnetzteil mit einer Steuerschaltung, mit zwei Leistungsschaltern in Halbbrückenanordnung, deren Verbindungsknoten über eine Serienschaltung aus der Primärwicklung eines Transformators, einer Induktivität und eines Kondensators an ein Bezugspotential geschaltet ist. Durch zwei entsprechend geschaltete Klemmdioden wird hierbei verhindert, daß die Spannung über dem besagten Kondensator das obere oder untere Versorgungspotential nennenswert über- bzw. unterschreiten kann. Die Sekundärseite des Transformators ist über eine Zweiweg- oder Vollwellengleichrichtung an einen Glättungskondensator geschaltet, zu dem eine Last parallel geschaltet werden kann. Über eine Regelschleife wird die Sekundärspannung durch Veränderung der Ansteuerimpulstaktfrequenz konstant gehalten, die über ein VCO gesteuert wird. Der Stromnulldurchgang wird durch einen Nulldurchgangsdetektor erfaßt und die Dauer eines jeden Ansteuerimpulses wird in Abhängigkeit vom Stromnulldurchgang geregelt. Aus Kammiller sind Ausführungsformen des Steuerteiles gattungsgemäßer Schaltnetzteile bekannt.

Aus dem Artikel von D.A.PASSEY et al., "Arc suppression of a DC energized contactor under inductive load", aus IEEE Transactions on Industry Applications, Vol.IA.2l, No.6, Nov./Dez. l985, Seiten l354-l358, sind ein Verfahren und eine Steuerschaltung bekannt, welche das Öffnen und Schließen eines Schalters im Nulldurchgang bewirken, wobei der Zeitfehler zwischen Ansteuern und Schließen des Schalters benutzt wird, um den Zeitablauf zu adaptieren.

Aufgabe der Erfindung ist das Bereitstellen eines Verfahrens, das bei Resonanzwandlerschaltnetzteilen ein Ein- und Ausschalten im Nulldurchgang des Primärstromes oder der Primärspannung, unabhängig von im zugelassenen Bereich sich ändernder Eingangsspannung, von im zugelassenen Bereich sich ändernder Last und von der Signallaufzeit der Regelschleife ermöglicht sowie Schaltungsanordnungen zur Durchführung des Verfahrens.

Diese Aufgabe wird durch ein Verfahren nach dem Patentanspruch l bzw. eine Schaltungsanordnung nach dem Patentanspruch 7 gelöst. Günstige Ausgestaltungsformen sind Gegenstand von Unteransprüchen.

Im Folgenden wird die Erfindung anhand von Ausführungsbeispielen in den Figuren l und 2 näher erläutert. Es zeigt:

Figur l ein Prinzipschaltbild eines erfindungsgemäßen Eintakt-Zero-Voltage-Switch-Resonanzwandlernetzteiles,

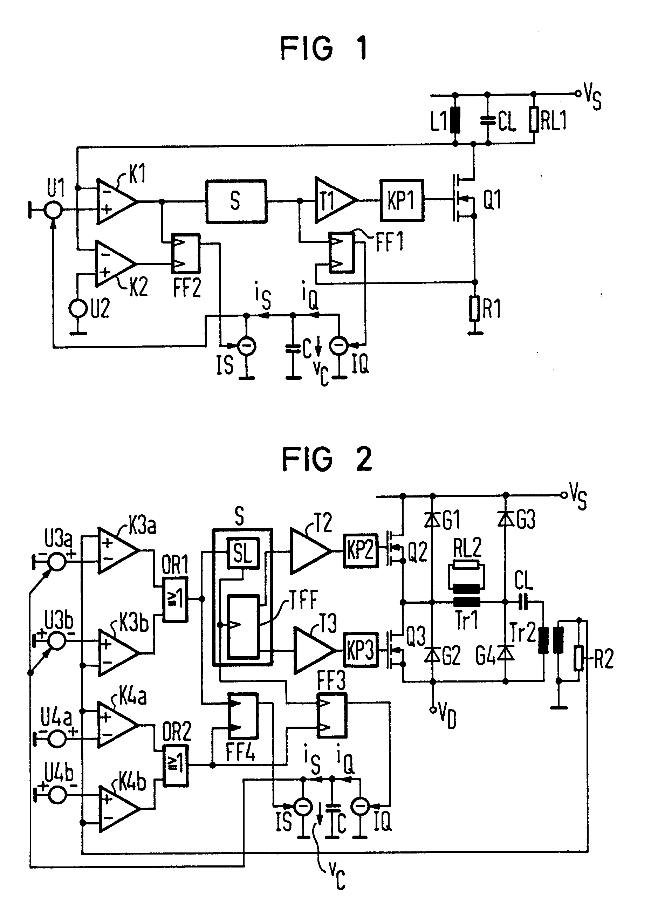

Figur 2 ein Prinzipschaltbild eines erfindungsgemäßen Gegentakt-Zero-Current-Switch-Resonanzwandlernetzteiles und

Da gattungsgemäße Resonanzwandler-Schaltnetzteile, zumindest als Zero-Current-Switch-Resonanzwandler, in der obengenannten EP-Al-0 293 874 eingehend beschrieben sind und auch übliche Steuerteile zur Ansteuerung der Leistungstransistoren solcher Schaltnetzteile unter anderem aus den obengenannten Veröffentlichungen hinlänglich bekannt sind, wird nachstehend auf die Beschreibung des konkreten Aufbaues von Schaltungen, die dem Fachmann bekannt sind, wie z.B. Treiberstufen, Steuerteile, Koppelnetzwerke und Komparatoren, nicht näher eingegangen. Auch Zero-Voltage-Switch-Resonanzwandler sind prinzipiell bekannt und die spezielle Ausführung solcher Schaltungen ist nach der Strom-Spannungs-Analogie (Duale Schaltungen) in bekannter Weise aus den beschriebenen Veröffentlichungen herleitbar.

Figur I zeigt als mögliches Ausführungsbeispiel ein erfindungsgemäßes Resonanzwandler-Schaltnetzteil vom Eintakt-Zero-Voltage-Switch-Typ. Bei einer Eintaktschaltung ist nur ein Leistungstransistor QI erforderlich. In Zero-Voltage-Switch-Resonanzwandlernetzteilen ist der Resonanzkreis als Parallelkreis ausgeführt, hier bestehend aus der Induktivität LI, der Kapazität CL und einem Leitwert, der durch den Widerstand RLI realisiert ist. Ein Betriebspotential $V_S$ ist über diesen Resonanzkreis LI, CL, RLI an den Drainanschluß des Leistungsschalttransistors QI geschaltet. Der Steuereingang des Leistungsschalttransistors QI ist über ein erstes Koppelnetzwerk KPI, das insbesondere einen Impulstransformator und eventuell ein Dämpfungsglied enthält, an den Ausgang einer ersten Treiberstufe TI angeschlossen. Der Eingang dieser ersten Treiberstufe TI ist mit dem Signalausgang eines Steuerteiles S verbunden. Dieses Steuerteil S ist in bekannter Weise aufgebaut und kann unter anderem eine Steuerlogikschaltung, einen Oszillator und verschiedene Schutzschaltungen, wie Unterspannungsschutz und Überstromschutz enthalten. Der Sourceanschluß des Leistungsschalttransistors QI ist über einen ersten Meßwiderstand RI an das Bezugspotential geschaltet. Die über diesen ersten Meßwiderstand RI abfallende Spannung kann hier als Indikator für den Schaltzustand des Leistungsschalttransistors QI dienen. Der Setzeingang eines ersten, auf steigende Flanken getriggerten RS-Flipflops FFI ist an den Signaleingang der ersten Treiberstufe TI angeschlossen. Hierbei ist wichtig, daß der Anschlußpunkt vor der ersten Treiberstufe liegt, er kann allerdings auch schon in dem Steuerteil S liegen. Der Rücksetzeingang des ersten Flipflops FFI ist mit dem Sourceanschluß des Leistungsschalttransistors QI verbunden. Der Ausgang des ersten Flipflops FFI ist an den Steuereingang einer schaltbaren Konstantstromquelle IQ geschaltet. Diese schaltbare Konstantstromquelle IQ ist derart geschaltet, daß sie im eingeschalteten Zustand mit einem Strom $i_Q$ einen gegen das Bezugspotential geschalteten Kondensator C auflädt. Eine schaltbare Konstantstromsenke IS ist derart geschaltet, daß sie im eingeschalteten Zustand diesen Kondensator C mit dem Strom $i_S$ entlädt. Der Verbindungspunkt zwischen dem Drainanschluß des Leistungsschalttransistors QI und dem Resonanzkreis LI, CL, RLI ist mit dem 2 invertierenden Eingang eines ersten Komparators KI und eines zweiten Komparators K2 verbunden. Der nichtinvertierende Eingang des zweiten Komparators K2 ist über eine Konstantstromquelle mit einem konstanten Potential derart beaufschlagt, daß der Komparator umschaltet, wenn am Drainanschluß des Leistungsschalttransistors QI die Spannung so klein ist, daß ein Schalten des Leistungsschalttransistors QI zu vernachlässigbar kleinen Leistungsverlusten führt. Der nichtinvertierende Eingang des ersten Komparators KI ist mit einer steuerbaren Spannungsquelle UI verbunden. Der Schaltungsknoten zwischen der Konstantstromquelle IQ, der Konstantstromsenke IS und dem Kondensator C ist an den Steuereingang dieser steuerbaren Spannungsquelle UI geschaltet. Der beschriebene Schaltungsteil, bestehend aus der schaltbaren Konstantstromquelle IQ, der schaltbaren Konstantstromsenke IS und dem Kondensator C stellt hierbei eine Zeitvergleichsstufe dar, bei der die Spannung $v_C$ über dem Kondensator C, die an dem Verbindungsknoten dieser drei Schaltungsteile IS, IQ und C abgegriffen werden kann, vom Vergleich der Zeitdauer eines im Steuereingang der Stromquelle IQ anstehenden Signals mit der Zeitdauer eines am Steuereingang der Stromsenke IS anstehenden Signals abhängt. In erfindungsgemäßen Schaltungen kann hier auch jede andere bekannte Zeitvergleichsstufe eingesetzt werden. Der Signalausgang des ersten Komparators KI ist an den Signaleingang des Steuerteiles S geschaltet und außerdem an den Setzeingang eines zweiten flankengetriggerten RS-Flipflops FF2. Der Signalausgang des zweiten Komparators K2 ist an den Rücksetzeingang des zweiten RS-Flipflops FF2 geschaltet und der Signalausgang des zweiten RS-Flipflops FF2 ist an den Steuereingang der Stromsenke IS engeschlossen.

Der erste Komparator KI ist üblicherweise so eingestellt, daß seine Schaltschwelle oberhalb der einen Nulldurchgang angebenden Schaltschwelle des zweiten Komparators K2 liegt.

Oben beschriebene, durch Komparatoren realisierte Nulldurchgangsdetektoren haben eine Signallaufzeit von ca. 5 bis I0 ns. Auch die Signallaufzeit durch bekannte Steuerteile S liegt im Nannosekunden-Bereich und ist somit verschwindend gering gegen die Signallaufzeit, mit der eine schnelle Treiberstufe TI, eine schnelle Koppelschaltung KPI und ein Leistungsschalttransistor QI behaftet sind. Die Signallaufzeit durch eine solche Schaltungskette TI, KPI, QI liegt in der Größenordnung von 80 bis I00 ns. Deshalb kann die Laufzeit durch die Treiberstufe, die Koppelstufe und den Leistungsschalttransistor in guter Näherung gleich der Laufzeit einer gesamten Regelschaltung, bestehend aus Treiberstufe, Koppelschaltung, Leistungsschalttranssistor, Nulldurchgangsdetektor und Steuerteil. In einer Schaltung nach Figur I wird das erste RS-Flipflop FFI mit dem Ansteuersignal der ersten Treiberstufe TI gesetzt. Sobald der Leistungsschalttransistor QI schaltet, wird das erste Flipflop FFI zurückgesetzt. Solange das erste Flipflop FFI gesetzt ist, ist die schaltbare Konstantstromquelle IQ eingeschaltet und lädt mit einem konstanten Strom $i_Q$ den Kondensator C auf. Die Ladungsmenge im Kondensator C ist somit ein Maß für die Signallaufzeit durch die Treiberstufe TI, das Koppelnetzwerk KPI und den Schalttransistor QI. Der Komparator KI, der vor Erreichen des echten Nulldurchganges der Spannung am Drainanschluß des Leistungsschalttransistors QI ein Signal an den Steuerteil S abgibt, setzt das zweite RS-Flipflop FF2. Im vom zweiten Komparator K2 erfaßten Nulldurchgang der Drainspannung des Leistungsschalttransistors QI wird das zweite Flipflop FF2 zurückgesetzt.

Somit ist das zweite Flipflop FF2 während der Vorhaltezeit, mit der der erste Komparator Kl vor dem tatsächlichen Nulldurchgang schaltet, gesetzt. Während das zweite Flipflop FF2 gesetzt ist, wird über die schaltbare Konstantstromsenke IS der Kondensator C entladen. Ist die Signallaufzeit, während der das erste Flipflop FFl gesetzt ist genauso groß wie die im ersten Komparator Kl eingestellte Vorhaltezeit, während der das zweite Flipflop FF2 gesetzt ist, so bleibt die über den Kondensator C abfallende Spannung $v_C$ im Mittel konstant und die den Vorhalt einstellende, von der steuerbaren Spannungsquelle Ul gelieferte Spannung am nichtinvertierenden Eingang des ersten Komparators Kl wird nicht verändert. Weicht die Vorhaltezeit von der Signallaufzeit ab, so führt dies zu einer entsprechenden Änderung der Spannung $v_C$ und über die steuerbare Spannungsquelle Ul wird die Vorhalteschwelle entsprechend nachgeführt.

Die Spannungsänderung $dv_C$ an dem Kondensator C setzt sich im Ausführungsbeispiel nach Figur l folgendermaßen zusammen:

$$dv_C = (i_Q \, t_{Tl,KPl,Ql} - i_S \, t_{Kl}) \, l/C$$

wobei $t_{Tl,KPl,Ql}$ der Laufzeit durch die Treiberstufe Tl, das Koppelnetzwerk KPl und den Leistungsschalttransistor Ql entspricht und $t_{Kl}$ der Vorhaltezeit des Nulldurchgangsdetektors entspricht. Wenn $i_S$ und $i_Q$ gleichgroß sind, erhält man eine Vorhaltezeit $t_{Kl}$, die so eingestellt ist, daß der Leistungsschalttransistor Ql im Spannungsnulldurchgang schaltet. Die Vorhaltezeit wird hierbei bis auf einen Restfehler ausgeregelt, wobei der Restfehler der Laufzeit durch den Komparator Kl und durch den Steuerteil S entspricht.

Bei Erreichen eines in den Steuerteil S durch die Regelung vorgegebenen maximalen Stromwertes schaltet der Steuerteil S den Leistungsschalttransistor Ql ab.

Figur 2 zeigt ein Prinzipschaltbild eines erfindungsgemäßen Gegentakt-Zero-Current-Switch-Resonanzwandlernetzteiles, wobei in diesem Ausführungsbeispiel zwei Leistungsschalttransistoren Q2 und Q3 vorgesehen sind, der zweite Leistungsschalttransistor Q2 zum Schalten der positiven Halbwelle und der dritte Leistungsschalttransistor Q3 zum Schalten der negativen Halbwelle. Der Drainanschluß des zweiten Leistungsschalttransistors Q2 ist mit einem Versorgungspotential $V_S$ verbunden, der Sourceanschluß dieses zweiten Leistungsschalttransistors Q2 ist mit dem Drainanschluß des dritten Leistungsschalttransistors Q3 sowie mit der Primärwicklung des Transformators Trl verbunden und über eine erste Schaltdiode Gl an das Versorgungspotential $V_S$ geklemmt sowie über eine zweite Schaltdiode G2 an das negative Versorgungspotential $V_D$, das mit dem Sourceanschluß des dritten Leistungsschalttransistors Q3 verbunden ist, geschaltet. Der Transformator Trl ist mit einer Last RL2 belastet. Der andere Anschluß der Primärwicklung des Transformators Trl ist über eine dritte Schaltdiode G3 ebenfalls an das Versorgungspotential $V_S$ geklemmt und außerdem sowohl über eine vierte Schaltdiode G4 als auch über die Serienschaltung aus einem Kondensator CL und der Primärwicklung eines Stromfühler-Transformators Tr2 an das negative Versorgungspotential $V_D$ geschaltet. Der Resonanzkreis dieses Resonanzwandler-Schaltnetzteiles ist durch den Serienkreis, bestehend aus der Primärwicklung des Transformators Trl und dem Kondensator CL sowie der Primärwicklung des Stromfühler-Transformators Tr2 gegeben, wobei die Induktivität der Primärwicklung des Transformators Trl zusammen mit der Kapazität des Kondensators CL die Referenzfrequenz dieses Resonanzkreises festlegt und die Primärwicklung des Stromfühler-Transformators Tr2 aufgrund des hohen Windungsverhältnisses dieses Transformators vernachlässigbar ist. Der Sekundärkreis des Stromfühler-Transformators Tr2 ist mit einem zweiten Meßwiderstand R2 belastet, über den eine zum Primärstrom des Transformators Trl äquivalente Spannung abfällt. Diese Spannung dient zur Beaufschlagung der Istwert-Eingänge zweier Fenster-Komparatoren K3a, K3b bzw. K4a, K4b.

Der erste dieser Fenster-Komparatoren, der durch die beiden Komparatoren K3a und K3b sowie ein erstes ODER-Glied ORl realisiert ist, hat hierbei eine etwas größere Fensterbreite, wobei die Fenster-Grenzwerte durch die steuerbaren Spannungsquellen U3a und U3b einstellbar sind. Der Ausgang des ersten ODER-Gliedes ORl, der dem Ausgang des ersten Fenster-Komparators entspricht, ist an den Signaleingang des Steuerteiles S, insbesondere an den Eingang der darin enthaltenen Steuerlogikschaltung SL sowie an den Setzeingang eines vierten, flankengesteuerten RS-Flipflops FF4 geschaltet. In Figur 2 ist dieses flankengetriggerte RS-Flipflop FF4 als auf die fallende Flanke getriggert gezeichnet, weil zur Verknüpfung der beiden Komparatoren K3a und K3b aufgrund der kürzeren Signallaufzeit ein ODER-Glied und kein Nicht-ODER-Glied verwendet wurde. Der zweite, durch die Komparatoren K4a und K4b sowie ein zweites ODER-Glied OR2 realisierte Fenster-Komparator hat ein gegenüber dem ersten Fenster-Komparator enges Fenster, das durch die beiden Konstantspannungsquellen U4a und U4b eingestellt ist. Der den Ausgang dieses zweiten Fenster-Komparators bildende Ausgang des zweiten ODER-Gliedes OR2 ist mit dem Rücksetzeingang des vierten RS-Flipflops FF4 sowie mit dem Rücksetzeingang des dritten RS-Flipflops FF3 zusammengeschaltet. Der Ausgang der obengenannten Steuerlogikschaltung SL ist an den Eingang eines Teilerflipflops TFF geschaltet sowie an den Setzeingang des dritten RS-Flipflops FF3. Die beiden Ausgänge des Teilerflipflops TFF bilden die Ausgänge des Steuerteiles S, wobei der eine Ausgang an den Signaleingang der zweiten Treiberstufe T2 und der andere Ausgang an den Signaleingang der dritten Treiberstufe T3 geschaltet ist. Der Ausgang des dritten RS-Flipflops FF3 ist entsprechend dem Ausgang des ersten RS-Flipflops FFl in Figur l an einen Eingang einer Zeitvergleicherstufe IS, IQ, C geschaltet, der Ausgang des vierten RS-Flipflops FF4 ist entsprechend dem Ausgang des zweiten RS-Flipflops FF2 in Figur I an den anderen Eingang dieser Zeitvergleicherstufe IS, IQ, C geschaltet und der Ausgang dieser Zeitvergleicherstufe dient analog zur in Figur I gezeigten Schaltung zur Beeinflussung der steuerbaren Spannungsquellen U3a und U3b. Der Ausgang der zweiten Treiberstufe T2 ist mit dem Eingang eines zweiten Koppelnetzwerkes KP2 verbunden, dessen Ausgang mit dem Steuereingang des zweiten Leistungsschalttransistors Q2 zusammengeschaltet ist. Der Ausgang der dritten Treiberstufe T3 ist an den Eingang eines dritten Koppelnetzwerkes KP3 angeschlossen, dessen Ausgang mit dem Steuereingang des dritten Leistungsschalttransistors Q3 zusammengeschaltet ist.

Die zweite Treiberstufe T2, das zweite Koppelnetzwerk KP2 und der zweite Leistungsschalttransistor Q2 sowie die dritte Treiberstufe T3, das dritte Koppelnetzwerk KP3 und der dritte Leistungsschalttransistor Q3 sollten möglichst symmetrisch aufgebaut sein. Wenn die Steuerlogikschaltung SL ein Schaltsignal an einen der Leistungsschalttransistoren Q2 oder Q3 abschickt, wird das dritte RS-Flipflop FF3 gesetzt. Wenn einer der beiden Leistungsschalttransistoren Q2 oder Q3 schaltet, verläßt der Spannungspegel, der über den zweiten Meßwiderstand R2 abfällt, den Nullpegel. Dies führt zu einer ansteigenden Flanke am Ausgang des zweiten Fenster-Komparators K4a, K4b, OR2, so daß das dritte RS-Flipflop FF3 zurückgesetzt wird. Somit ist das dritte RS-Flipflop FF3 für die Dauer der Signallaufzeit durch das Teilerflipflop TFF sowie die Treiberstufe T2, T3, das Koppelnetzwerk KP2, KP3 und einen Leistungsschalttransistor Q2, Q3 gesetzt. Während dieser Zeit wird der Kondensator C über die Konstantstromquelle IQ mit dem konstanten Strom $i_Q$ aufgeladen. Unterschreitet die über dem zweiten Meßwiderstand R2 abfallende Spannung ihrem Betrage nach eine bestimmte, durch die steuerbaren Spannungsquellen U3a und U3b eingestellte Schwelle, so erscheint am Ausgang des ersten Fenster-Komparators, und somit am Ausgang des ersten ODER-Gliedes ORI eine fallende Flanke, die die Steuerlogik SL freigibt und außerdem das vierte RS-Flipflop FF4 setzt. Fällt die über dem zweiten Meßwiderstand R2 abfallende Spannung dem Betrage nach unter die den tatsächlichen Nulldurchgang darstellende Schwelle, die von den Konstantspannungsquellen U4a und U4b festgesetzt ist, so erscheint am Ausgang des zweiten ODER-Gatters OR2 eine fallende Flanke, die das dritte RS-Flipflop FF3 nicht beeinflußt, jedoch das vierte RS-Flipflop FF4 zurücksetzt. Das vierte RS-Flipflop FF4 ist also für die Zeit gesetzt, die zwischen dem Schalten des ersten Fenster-Komparators (mit größerer Fensterbreite) und dem Schalten des zweiten Fenster-Komparators (mit enger Fensterbreite) liegt. Während das vierte RS-Flipflop FF4 gesetzt ist, entlädt die schaltbare Stromsenke IS den Kondensator C mit dem konstanten Strom $i_S$. Die über den Kondensator C abfallende Spannung $v_C$ enthält somit ein Regelsignal $dv_C$, das folgendermaßen gewonnen wird:

$$dv_C = (i_Q t_K - i_S t_{K3}) / C,$$

wobei $t_{K3}$ der Vorhaltezeit des Nulldurchgangsdetektors entspricht und $t_K$ dem Mittelwert der Signallaufzeiten durch die Treiberstufe T2 bzw. T3, das Koppelnetzwerk KP2 bzw. KP3 und den Leistungsschalttransistor Q2 bzw. Q3 sowie das Teilerflipflop TFF entspricht.

Da bei Gegentakt-Resonanzwandler-Schaltnetzteilen erst nach Abschalten des einen Schalttransistors der andere Schalttransistor erneut eingeschaltet werden darf, ist aus Sicherheitsgründen bei gattungsgemäßen Schaltnetzteilen immer eine Totzeit zwischen dem tatsächlichen Nulldurchgang der elektrischen Referenzgröße und dem Wiedereinschalten des Schalttransistors erforderlich. Bei erfindungsgemäßen Schaltungen kann diese Totzeit auf ein vernachlässigbares Maß reduziert werden. Dadurch kann die gleiche Leistung bei einem geringeren Spitzenstrom bzw. eine höhere Leistung bei gleichem Spitzenstrom übertragen werden, was zu einer Erhöhung des Ausnutzungsgrades der Leistungsbauelemente des Resonanzwandler-Schaltnetzteiles führt.

Auch bei erfindungsgemäßen Eintakt-Resonanzwandler-Schaltnetz teilen läßt sich durch entsprechendes Anpassen der Einschaltzeitpunkte an den tatsächlichen Verlauf der elektrischen Referenzgröße dieser Ausnutzungsgrad erhöhen.

## Patentansprüche

1. Verfahren zur Regelung der Ansteuersignale der Schalttransistoren in einem Resonanzwandlerschattnetzteil mit einer von der Nulldurchgangserkennung von an der Lastseite der Schalttransistoren auftretenden Signalen abhängigen Regelung, wobei zur Ermittlung einer Zeitpunktes vor dem tatsächlichen Nulldurchgang ein Nulldurchgansdetektor (K1, K3a, K3b) mit einer variabel einstellbaren Vorhalteschwelle vorgesehen ist,

   **dadurch gekennzeichnet,**

   daß ein Vergleich der Zeitdauer, welche zwischen dem Generieren eines Ansteuersignales und dem Schalten eines der Schalttransistoren liegt, mit dem Zeitabstand des Ansprechens des vor dem tatsächlichen Nulldurchgang ansprechenden Nulldurchgangsdetektors vom tatsächlichen Nulldurchgang, zur Ge-

6

winnung eines Regelsignales zur Steuerung der einstellbaren Vorhalteschwelle dieses Nulldurchgangsdetektors vorgesehen ist.

2. Verfahren nach Anspruch 1,
**dadurch gekennzeichnet,**
daß der tatsächliche Nulldurchgang mittels eines weiteren Nulldurchgangsdetektors (K2,K4a,K4b) ermittelt wird, und,
daß die Freigabe der Ansteuersignale durch den beim tatsächlichen Nulldurchgang ansprechenden Nulldurchgangsdetektor (K2,K4a,K4b) und den vor dem tatsächlichen Nulldurchgang ansprechenden Nulldurchgangsdetektor (K1, K3a, K3b) bewirkt wird.

3. Verfahren nach Anspruch I oder 2,
**dadurch gekennzeichnet,**
daß das Resonanzwandlerschaltnetzteil nach dem Zero-Current-Switch-Verfahren arbeitet.

4. Verfahren nach Anspruch I oder 2,
**dadurch gekennzeichnet,**
daß das Resonanzwandlerschaltnetzteil nach dem Zero-Voltage-Switch-Verfahren arbeitet.

5. Verfahren nach Anspruch I bis 4,
**dadurch gekennzeichnet,**
daß das Resonanzwandlerschaltnetzteil nach dem Eintakt-Verfahren arbeitet.

6. Verfahren nach Anspruch I bis 4,
**dadurch gekennzeichnet,**
daß das Resonanzwandlerschaltnetzteil nach dem Gegentakt-Verfahren arbeitet.

7. Schaltungsanordnung zur Regelung der Ansteuersignale der Schalttransistoren in einem Resonanzwandlerschattnetzteil mit einer von der Nulldurchgangserkennung von an der Lastseite der Schalttransistoren auftretenden Signalen abhängigen Regelung, wobei ein vor dem tatsächlichen Nulldurchgang ansprechender Nulldurchgangsdetektor (KI, K3a, K3b) mit einer variabel einstellbaren Vorhalteschwelle vorgesehen ist,
**dadurch gekennzeichnet,**
daß außer dem Nulldurchgangsdetektor mit variabel enstellbarer Vorhalt eschwelle (KI, K3a, K3b) noch ein Nulldurchgangsdetektor mit fest eingestellter Vorhalteschwelle (K2, K4a, K4b) vorgesehen ist, daß das Ansteuersignal mindestens einer Treiberstufe (TI, T3) zur Beaufschlagung des Setz-Einganges eines auf steigende Flanken getriggerten ersten RS-Flipflops (FFI, FF3) vorgesehen ist, daß dieses erste RS-Flipflop (FFI, FF3) in Abhängigkeit vom Schaltzustand des durch die entsprechende Treiberstufe (TI, T3) angesteuerten Schalttransistors (QI, Q3) zurückgesetzt wird, daß der Ausgang dieses ersten RS-Flipflops mit einem Eingang einer Zeitvergleichsstufe (IQ, IS, C) verbunden ist, daß der Ausgang des Nulldurchgangsdetektors mit variabel einstellbarer Vorhalteschwelle (KI, K3a, K3b) an den Setz-Eingang eines zweiten flankengetriggerten RS-Flipflops (FF2, FF4) geschaltet ist, daß der Ausgang des Nulldurchgangsdetektors mit fest eingestellter Vorhalteschwelle (K2, K4a, K4b) an den Rücksetz-Eingang dieses zweiten RS-Flipflops geschaltet ist, daß der Ausgang des zweiten RS-Flipflops mit einem anderen Eingang der Zeitvergleichsstufe (IQ, IS, C) verbunden ist und daß das am Ausgang der Zeitvergleichsstufe (IQ, IS, C) anstehende Vergleichsergebnis der Signaldauer der Ausgangssignale der beiden RS-Fliplfops (FFI, FF3; FF2, FF4) zur Steuerung der Vorhalteschwelle des Nulldurchgangsdetektors mit variabel einstellbarer Vorhalteschwelle (KI, K3a, K3b) vorgesehen ist.

8. Schaltungsanordnung nach Anspruch 7,
**dadurch gekennzeichnet,**
daß die Zeitvergleichsstufe aus einer schaltbaren Stromquelle (IQ), einer schaltbaren Stromsenke (IS) und einem Kondensator (C) besteht, daß der Steuereingang der Stromquelle (IQ) den einen Eingang der Zeitvergleichsstufe und der Steuereingang der Stromsenke (IS) den anderen Eingang der Zeitvergleichsstufe bildet, daß die Stromquelle (IQ) zum Laden und die Stromsenke (IS) zum Entladen des Kondensators (C) vorgesehen ist und daß der über dem Kondensator (C) anstehende momentane Spannungswert als Ausgangsgröße der Zeitvergleichsstufe vorgesehen ist.

## Claims

1. Method for the closed-loop control of the trigger signals of switching transistors in a resonant converter switched-mode power supply having a closed-loop control dependent on the zero-crossing detection of signals occurring at the load side of the switching transistors, a zero-crossing detector (K1, K3a, K3b) with a variably adjustable derivative action threshold being provided for determining an instant before the actual zero crossing, characterised in that a comparison of the time interval between the generation of a trigger signal and the switching of one of the switching transistors with the time interval between the response of the zero-crossing detector responding before the actual zero crossing and the actual zero crossing is provided for obtaining a closed-loop control signal for controlling the adjustable derivative action threshold of said zero-crossing detector.

2. Method according to Claim 1, characterised in that the actual zero crossing is determined by means of a further zero-crossing detector (K2, K4a, K4b), and in that the enabling of the trigger signals is effected by the zero-crossing detector (K2, K4a, K4b) responding at the actual zero crossing and the zero-crossing detector (K1, K3a, K3b) responding before the actual zero crossing.

3. Method according to Claim 1 or 2, characterised in that the resonant converter switched-mode power supply operates according to the zero current switch method.

4. Method according to Claim 1 or 2, characterised in that the resonant converter switched-mode power supply operates according to the zero voltage switch method.

5. Method according to Claims 1 to 4, characterised in that the resonant converter switched-mode power supply operates according to the single phase method.

6. Method according to Claims 1 to 4, characterised in that the resonant converter switched-mode power supply operates according to the push-pull method.

7. Circuit arrangement for the closed-loop control of the trigger signals of switching transistors in a resonant converter switched-mode power supply having a closed-loop control dependent on the zero-crossing detection of signals occurring at the load side of the switching transistors, a zero-crossing detector (K1, K3a, K3b) with a variably adjustable derivative action threshold which responds before the actual zero crossing being provided, characterised in that, in addition to the zero-crossing detector with variably adjustable derivative action threshold (K1, K3a, K3b), a further zero-crossing detector with set fixed derivative action threshold (K2, K4a, K4b) is provided, in that the trigger signal of at least one driver stage (T1, T3) is provided for application to the set input of a first RS flip-flop (FF1, FF3) triggered by leading edges, in that said first RS flip-flop (FF1, FF3) is reset depending on the switching state of the switching transistor (Q1, Q3) triggered by the corresponding driver stage (T1, T3), in that the output of said first RS flip-flop is connected to one input of a time comparison stage (IQ, IS, C), in that the output of the zero-crossing detector with variably adjustable derivative action threshold (K1, K3a, K3b) is connected to the set input of a second edge-triggered RS flip-flop (FF2, FF4), in that the output of the zero-crossing detector with set fixed derivative action threshold (K2, K4a, K4b) is connected to the reset input of said second RS flip-flop, in that the output of the second RS flip-flop is connected to another input of the time comparison stage (IQ, IS, C), and in that the comparison result of the signal duration of the output signals of the two RS flip-flops (FF1, FF3; FF2, FF4) present at the output of the time comparison stage (IQ, IS, C) is provided for controlling the derivative action threshold of the zero-crossing detector with variably adjustable derivative action threshold (K1, K3a, K3b).

8. Circuit arrangement according to Claim 7, characterised in that the time comparison stage consists of a switchable current source (IQ), a switchable current sink (IS) and a capacitor (C), in that the control input of the current source (IQ) forms one input of the time comparison stage and the control input of the current sink (IS) forms the other input of the time comparison stage, in that the current source (IQ) is provided for charging and the current sink (IS) is provided for discharging the capacitor (C), and in that the instantaneous voltage value present across the capacitor (C) is provided as output variable of the time comparison stage.

## Revendications

1. Procédé pour régler les signaux de commande des transistors de commutation dans un bloc d'alimentation secteur commuté à convertisseur fonctionnant à la résonance, avec une régulation qui dépend de l'identification d'annulations de signaux apparaissant sur le côté de charge des transistors de commutation, selon lequel, pour déterminer un instant avant l'annulation effective, il est prévu un détecteur d'annulations (K1, K3a, K3b) possédant un seuil de dérivation réglable de façon variable, caractérisé par le fait qu'il est prévu une comparaison de la durée, et la commutation des transistors de commutation, un intervalle de temps entre la réponse du détecteur d'annulations, qui répond avant l'annulation effective, et cette annulation effective, pour l'obtention d'un signal de régulation servant à commander le seuil de dérivation réglable de ce détecteur d'annulations.

2. Procédé suivant la revendication 1, caractérisé par le fait que l'annulation effective est déterminée au moyen d'un autre détecteur d'annulations (K2,K4a,K4b), et que la libération des signaux de commande est déclenchée par le détecteur d'annulations (K2,K4a,K4b), qui répond lors de l'annulation effective, et par le détecteur d'annulations (K1,K3a,K3b), qui répond avant l'annulation effective.

3. Procédé suivant la revendication 1 ou 2, caractérisé par le fait que le bloc d'alimentation secteur commuté à convertisseur fonctionnant à la résonance fonctionne selon le procédé Zero-Current-Switch, c'est-à-dire de commutation à courant nul.

4. Procédé suivant la revendication 1 ou 2, caractérisé par le fait que le bloc d'alimentation secteur commuté à convertisseur fonctionnant à la résonance fonctionne selon le procédé Zero-Voltage-Switch, c'est-à-dire de commutation à tension nulle.

5. Procédé suivant les revendications 1 à 4, caractérisé par le fait que le bloc d'alimentation secteur à convertisseur fonctionnant à la résonance travaille selon le procédé en phase.

6. Procédé suivant les revendications 1 à 6, caractérisé par le fait que le bloc d'alimentation secteur commuté à convertisseur fonctionnant à la résonance travaille selon le procédé en opposition de phase.

7. Montage pour régler les signaux de commande des transistors de commutation dans un bloc d'alimentation secteur commuté à convertisseur fonctionnant à la résonance, avec une régulation qui dépend de l'identification d'annulations de signaux apparaissant sur le côté de charge des transistors de commutation, selon lequel il est prévu un détecteur d'annulations (K1,K3a,K3b) qui répond avant l'annulation effective et possède un seuil de dérivation réglable de façon variable, caractérisé par le fait qu'en dehors du détecteur d'annulations (K1,K3a,K3b) possédant un seuil de dérivation réglable de façon variable, il est en outre prévu un détecteur d'annulations (K2,K4a,K4b) comportant un seuil de dérivation réglable de façon fixe, que le signal de commande d'au moins un étage d'attaque (T1,T3) est destiné à charger l'entrée de positionnement d'une première bascule bistable de type RS (FF1,FF3) déclenchée par des flancs montants, que cette première bascule bistable de type RS (FF1,FF3) est ramenée à l'état initial en fonction de l'état de commutation du transistor de commutation (Q1,Q3) commandé par l'étage d'attaque correspondant (T1,T3), que la sortie de cette première bascule bistable de type RS est raccordée à une entrée d'un second circuit de comparaison de temps (IQ,IS,C), que la sortie du détecteur d'annulations (K1,K3a,K3b) possédant un seuil de dérivation réglable de façon variable est raccordée à l'entrée de positionnement d'une seconde bascule bistable de type RS (FF2,FF4) actionnée par les flancs des signaux, que la sortie du détecteur d'annulations (K2,K4a,K4b) possédant un seuil de dérivation réglable de façon fixe est raccordée à l'entrée de remise à l'état initial de cette seconde bascule bistable de type RS, que la sortie de la seconde bascule bistable de type RS est reliée à une autre entrée du circuit de comparaison de temps (IQ,IS,C) et que le résultat de la comparaison, qui apparaît à la sortie de l'étage de comparaison de temps (IQ,IS,C), concernant la durée des signaux de sortie des deux bascules bistables de type RS (FF1,FF3;FF2,FF4), sert à commander le seuil de dérivation du détecteur d'annulations (K1,K3a,K3b), qui possède un seuil de dérivation réglable de façon variable.

8. Montage suivant la revendication 7, caractérisé par le fait que l'étage de comparaison de temps est constitué par une source de courant commutable (IQ), un puits de courant commutable (IS) et un condensateur (C), que l'entrée de commande de la source de courant (IQ) constitue une entrée de l'étage de comparaison de temps et que l'entrée de commande du puits de courant (IS) constitue l'autre entrée du circuit de comparaison de temps, que la source de courant (IQ) sert à charger le condensateur (C) et que le puits de courant (IS) sert à décharger ce condensateur et que la valeur instantanée de la tension, présente aux bornes du condensateur (C), est utilisée comme grandeur de sortie de l'étage de comparaison de temps.

# FIG 1

# FIG 2